# Europäisches Patentamt

# European Patent Office

# Office européen des brevets

(19)

(11) Veröffentlichungsnummer: **0 073 979**
**B1**

(12) **EUROPÄISCHE PATENTSCHRIFT**

(45) Veröffentlichungstag der Patentschrift:
18.12.85

(51) Int. Cl.⁴: **H 03 M 13/00, G 06 F 11/10,**
**H 04 B 7/185**

(21) Anmeldenummer: 82107562.9

(22) Anmeldetag: 19.08.82

(54) System zur Übertragung digitaler Informationssignale.

(30) Priorität: 03.09.81 DE 3134831

(43) Veröffentlichungstag der Anmeldung:
16.03.83 Patentblatt 83/11

(45) Bekanntmachung des Hinweises auf die Patenterteilung:
18.12.85 Patentblatt 85/51

(84) Benannte Vertragsstaaten:
AT BE CH DE FR GB IT LI LU NL SE

(56) Entgegenhaltungen:
EP - A - 0 034 036
DE - A - 2 657 826
DE - B - 2 060 643

THE BELL SYSTEM TECHNICAL JOURNAL, Vol. 51, No. 2, Februar 1972, New York (US) V. AHAMED "The design and embodiment of magnetic domain encoders and single error correcting decoders for cyclic block codes" Seiten 461-485

(73) Patentinhaber: Licentia Patent-Verwaltungs-GmbH,
Theodor-Stern-Kai 1, D-6000 Frankfurt/Main 70 (DE)

(72) Erfinder: Korte, Herman Wilhelm Werner, Dipl.-Ing.,
Masurenweg 46, D-3002 Wedemark 1, OT Mellendorf
(DE)
Erfinder: Stark, Dieter, Dipl.-Ing., Am Winkelberg 21,
D-3008 Garbsen 2 (DE)

## Beschreibung

Die Erfindung betrifft ein System zur Übertragung und eine Schaltungsanordnung zur Codierung und Decodierung digitaler Informationssignale, insbesondere für die digitale Tonübertragung über Satelliten.

Es ist bei der Übertragung von digitalen Datensignalen bekannt, für die Korrektur von statistisch verteilten Fehlern zyklische Codes zu verwenden. Die Vorzüge dieser Codes sind der lineare systematische Blockaufbau bei nicht allzu grosser Redundanz sowie die einfache Realisierung mittels rückgekoppelter Schieberegister. Es sind Bose-Chaudhuri-Hocquenghem-Codes, nachfolgend BCH-Codes genannt, bekannt, die in der Lage sind, bei einer vorgegebenen Blocklänge eine bestimmte Anzahl von Informationsbits zu übertragen und bei einer sich aus diesen Codes ergebenden minimalen Hammingdistanz eine bestimmte Anzahl von Fehlern zu korrigieren.

Bei der digitalen Informationsübertragung, z.B. über Satelliten, treten nur statistisch verteilte Einzelbitfehler (Gausssches Rauschen) auf, wie in «British Telecommunications: OTS and Digital Television Transmittion Investigation of Error Statistics relevant to the design of Error Correctors for Television (20.11.80)» beschrieben wird. Für die Korrektur von statistisch verteilten Fehlern eignen sich im hohen Masse die zyklischen Codes.

In der DE-A1- 26 57 826 ist eine Einrichtung zum Erkennen und Korrigieren von Zwei-Bit-Fehlern sowie einer Dreifachfehlererkennung beschrieben. Durch arithmetische Verknüpfung zweier Maximal-Generatorpolynome wird ein zweifehlerkorrigierender BCH-Code 57/15 erstellt.

Es wird also ein gültiges BCH-Code Generatorpolynome mit erhöhter Fehlererkennung und -Korrektur erzeugt. Zur Erkennung eines dritten Fehlers, der beim Auftreten zum Abschalten des Decoders und nicht zu einer Interpolation führt, wird dem BCH-Code ein übergreifendes Paritätsbit hinzugefügt.

Aufgabe der Erfindung ist es, ein System zu finden, das unter vorgegebenen Gütekriterien ein verbessertes Fehlerkorrektursystem für digitale Informationsübertragung ermöglicht und sich durch geringen schaltungstechnischen Aufwand von Coder und Decoder auszeichnet.

Diese Aufgabe wird durch die im Patentanspruch 1 angegebene Erfindung gelöst.

Vorteilhafte Weiterbildungen der Erfindung sind in den Unteransprüchen angegeben.

Das erfindungsgemässe System zeichnet sich dadurch aus, dass durch arithmetische Verknüpfung des durch sein Generatorpolynom vollständig beschriebenen BCH-Code mit einem weiteren Generatorpolynom die minimale Hammingdistanz erweitert wird und so eine erhöhte Fehlererkennung als bei dem ursprünglichen BCH-Code möglich ist. Die z.B. bei der digitalen Informationsübertragung über Satelliten geforderten Gütekriterien werden erfüllt und teilweise überschritten. Für die Festlegung der Gütekriterien sind zwei unterschiedliche Arten von Restfehlern, die nach der Decodierung verbleiben, zu unterscheiden. Es wird festgelegt, dass bei der Decodierung eine Zahl (g) von Fehlern sicher korrigiert und darüber hinaus eine andere Zahl (i) von Fehlern sicher erkannt werden, die aber nicht mehr korrigiert werden können, für die dann eine Interpolation erfolgt.

Für g < i sind zwei Fälle zu unterscheiden:

Treten mehr als g-Bitfehler in einem Block auf, so wird das decodierte Informationssignal durch einen im allgemeinen geringfügigen Inerpolationsfehler verfälscht. Treten mehr als i-Fehler auf, so wird eine fehlerhafte Decodierung durchgeführt, die mit einem deutlichen Knackgeräusch im decodierten Informationssignal verbunden ist.

Es werden folgende Gütekriterien postuliert:

Im zeitlichen Mittel soll ein Interpolationsfehler nicht mehr als einmal pro Sekunde sowie eine mittlere Übertragungszeit ohne Knackstörung von einer Stunde erreicht werden.

Anhand eines Ausführungsbeispiels wird das System näher erläutert.

Es zeigen:

Figur 1 eine Decoderschaltung

Figur 2 eine Tabelle.

Bei einer digitalen Informationsübertragung über Satelliten werden z.B. 16 PCM-Stereokanäle simultan übertragen. Bei der senderseitigen Multiplexbildung erscheint eine Aufteilung der Abtastwerte sinnvoll, wenn sie auf einem Raster von Potenzen von 2 aufbaut. Das führt auf eine Zuordnung der Informationsbits zu:

$$2^2 \text{ Abtastwerte a 11 Bit} = 44 \text{ Bit.}$$

Die Informationssignale können eine Folge von Datenwörtern aus einem Bündel zu übertragender Stereosignale zwei Stereokanäle oder vier Monosignale darstellen, wobei jeweils vier Datenworte der Informationssignale zusammengefasst werden.

Ein bekannter BCH-Code 63/45 ist in der Lage, 45 Informationsbits zu codieren. Das Generatorpolynom des bekannten BCH-Codes 63/45 wird erfindungsgemäss mit dem Generatorpolynom x + 1 multiplikativ erweitert und damit die minimale Hammingdistanz auf $d_{min} = 8$ erhöht. Daraus ergibt sich erfindungsgemäss der modifizierte BCH-Code 63/44.

Aus der Aufteilung der Informationsbits des gewählten BCH-Codes 63/44 ergibt sich eine Aufteilung der 14 Bits eines PCM-Abtastwertes in elf höherwertige Bit, die geschützt übertragen werden und drei niederwertige Bit, die ungeschützt übertragen werden.

Durch die Wahl des erfindungsgemässen BCH-Codes 63/44 ergibt sich eine Systemreserve, die durch die erhöhte minimale Hammingdistanz $d_{min} = 8$ gekennzeichnet ist. Daraus folgt ein zusätzlicher Freiheitsgrad bei der Auswahl des Decodieralgorithmus.

Durch die Unterteilung in

1. erkennbare und korrigierbare und

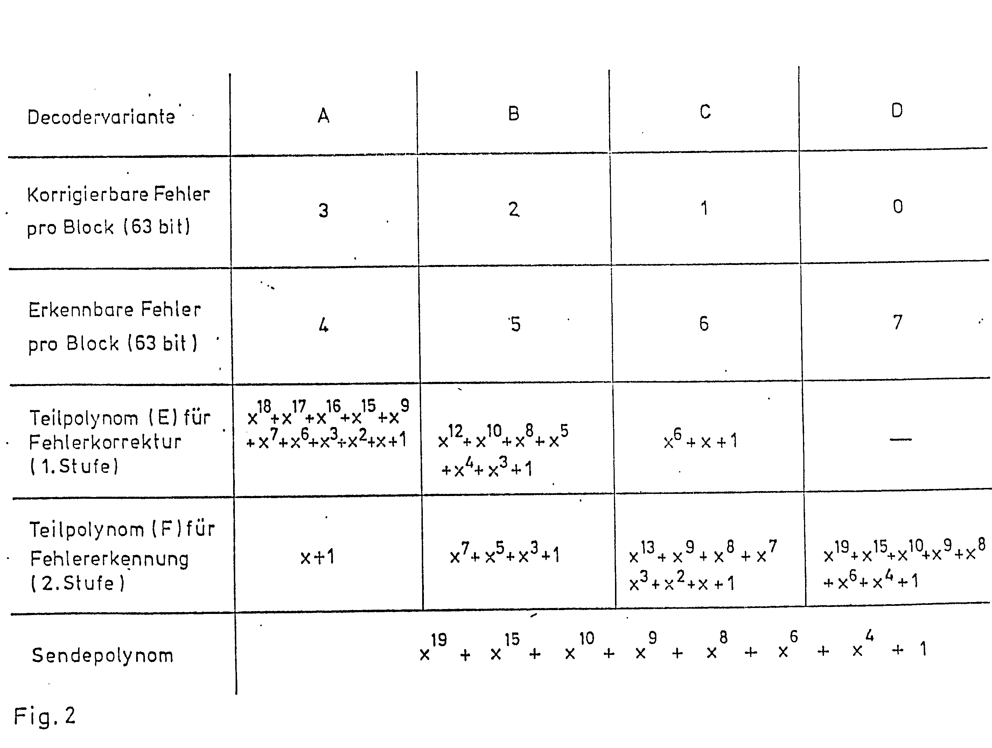

2. nur erkennbare Bitfehler ergeben sich folgende Varianten der Decodierung des erfindungsgemässen BCH-Codes 63/44 nach Figur 2.

A: Es sind drei Fehler pro Block korrigierbar und insgesamt vier Fehler pro Block erkannbar.

B: Es sind zwei Fehler pro Block korrigierbar und insgesamt fünf Fehler pro Block erkennbar.

C: Es sind ein Fehler pro Block korrigierbar und insgesamt sechs Fehler pro Block erkennbar.

D: Es sind insgesamt sieben Fehler pro Block erkennbar.

Bei den Decodierungsvarianten A und B werden die Gütekriterien der Restfehlerwahrscheinlichkeiten für eine Kanalfehlerwahrscheinlichkeit von $10^{-3}$ erfüllt. Die Variante B zeichnet sich zusätzlich dadurch aus, dass eine mittlere Übertragungszeit ohne Knackstörung von einer Stunde bei einer Bitfehlerwahrscheinlichkeit des Übertragungskanals von $3 \times 10^{-3}$ erreicht wird.

Die mittlere Übertragungszeit ohne jede Störung liegt bei 0,03 s. Daraus folgt eine Interpolationsrate von 33/s. Bezogen auf eine Bitfehlerwahrscheinlichkeit des Übertragungskanals von $10^{-3}$ wird eine mittlere Übertragungszeit ohne Kanalstörung von mehr als 5 Tagen erreicht. Die mittlere Übertragungszeit ohne jede Störung liegt bei ca. 1 Sekunde, d.h. die Interpolationsrate beträgt 1/s.

Der erfindungsgemässe BCH-Code 63/44 hat eine Blocklänge von 63 Bit. Die zu übertragende Information ist mit k = 44 Bit codiert. Die restlichen 19 Bit sind Prüfstellen. Der erfindungsgemässe BCH-Code 63/44 wird durch sein Generatorpolynom

$$x^{19} + x^{15} + x^{10} + x^9 + x^8 + x^6 + x^4 + 1$$

vollständig beschrieben.

Durch die Unterscheidung in 1. erkennbare und korrigierbare und 2. nur erkennbare Fehler ist ein zweistufiger Aufbau des Decoders vorteilhaft. Der Aufbau des erfindungsgemässen Decoders, der die ankommenden Informationssignale nach der oben aufgezeichneten Variante B decodiert, wird im folgenden anhand der Zeichnung näher erläutert.

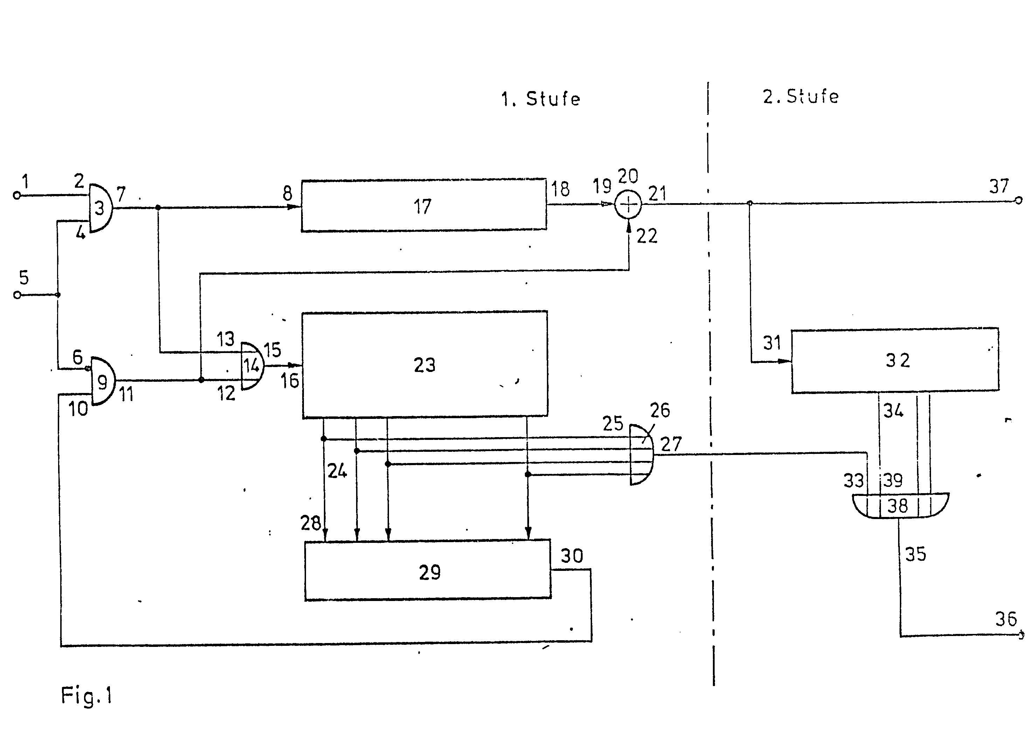

In der Figur 1 ist eine Decoderschaltung dargestellt. Die ankommenden Informationssignale werden über eine Eingangsklemme 1 einem Eingang 2 eines AND-Gatters 3 zugeführt. Ein weiterer Eingang 4 des AND-Gatters 3 ist sowohl mit einer Eingangsklemme 5 als auch mit einem invertierenden Eingang 6 eines AND-Gatters 9 verbunden. Der Ausgang 7 des AND-Gatters 3 ist mit dem Eingang 8 eines Speichers 17 und mit einem Eingang 13 eines OR-Gatters 14 verbunden. Der Ausgang 11 des AND-Gatters 9 ist sowohl mit einem weiteren Eingang 12 des OR-Gatters 14 als auch mit einem Eingang 22 eines EXOR-Gatters 20 verbunden. Der Ausgang 18 des Speichers 17 ist mit einem Eingang 19 des EXOR-Gatters 20 verbunden. Der Ausgang 15 des OR-Gatters 14 führt auf den Eingang 16 eines rückgekoppelten Speichers 23. Die dem Grad des rückgekoppelten Speichers 23 entsprechenden Ausgänge 24 führen sowohl auf entsprechende Eingänge 28 eines Festwertspeichers 29 als auch auf Eingänge 25 eines OR-Gatters 26. Der Ausgang 27 des OR-Gatters 26 führt auf einen Eingang 33 eines OR-Gatters 38. Der Ausgang 30 des Festwertspeichers 29 führt auf einen weiteren Eingang 10 des AND-Gatters 9. Der Ausgang 21 des EXOR-Gatters 20 ist mit einer Ausgangsklemme 37 und mit dem Eingang 31 eines weiteren rückgekoppelten Speichers 32 verbunden. Die dem Grad des rückgekoppelten Speichers 32 entsprechende Anzahl von Ausgängen 34 ist mit Eingängen 39 des OR-Gatters 38 verbunden. Der Ausgang 35 des OR-Gatters 38 ist mit einem Ausgang 36, über den ein Interpolationsaufruf vorgenommen werden kann, verbunden.

Im Decoder wird das zu decodierende 63-Bit-Codewort mit Hilfe der rückgekoppelten Speicher 23 und 32 auf Teilbarkeit durch das Generatorpolynom geprüft. Die erste Stufe, in der ein Fehler erkannt und korrigiert werden kann, besteht aus den AND-Gattern 3 und 9, den OR-Gattern 14 und 26, dem EXOR-Gatter 20, dem Speicher 17, dem rückgekoppelten Speicher 23 und dem Festwertspeicher 29. Die am Eingang 1 anliegenden Daten werden dann in den Speicher 17 eingelesen, wenn am Eingang 5 eine logische «1» anliegt.

Gleichzeitig mit dem Einlesen in den Speicher 17 werden die ankommenden Daten über das OR-Gatter 14 in den rückgekoppelten Speicher 23 eingelesen. In dem rückgekoppelten Speicher 23 wird das 63-Bit-Codewort auf Teilbarkeit durch das Teilpolynom E geprüft.

Nach der Einlesephase, die 63 Takte lang ist, wird am Eingang 5 eine logische «0» angelegt. Das AND-Gatter 3 wird damit für weitere ankommende Daten am Eingang 1 gesperrt. Nun beginnt die Korrigier- und Auslesephase. Das im rückgekoppelten Speicher 23 ermittelte Syndrom kennzeichnet vorhandene Fehler. Die den korrigierbaren Fehlermustern in Korrekturstellung umkehrbar eindeutig zugeordneten Syndrome sind vorausberechnet und als Adressen des Festwertspeichers 29 gekennzeichnet. Die Ausgänge 24 des rückgekoppelten Speichers 23 sind mit den Adresseingängen 28 des Festwertspeichers 29 verbunden, so dass immer dann, wenn ein Fehlermuster in Korrekturstellung durch das Syndrom im Festwertspeicher 29 angezeigt wird, am Ausgang des Festwertspeichers 29 ein Korrektursignal erscheint. Das Korrektursignal kann je nach Speicherkonzept eine logische «1» oder eine logische «0» sein.

Da in der Korrigier- und Auslesephase die Informationsbits taktweise aus dem 63-Bit Speicher 17 ausgelesen werden, liegt das erkannte fehlerhafte Bit am Eingang 19 des EXOR-Gatters 20 dann an, wenn am Ausgang 30 des Festwertspeichers 29 ein Korrektursignal vorhanden ist. Mit Hilfe des EXOR-Gatters 20 wird dann über das AND-Gatter 9 das fehlerhafte Bit korrigiert. Gleichzeitig wird über das OR-Gatter 14 das entsprechende Syndrom im rückgekoppelten Speicher 23 korrigiert. Nach Korrektur des fehlerhaften Bit und des Syndroms wird auf weitere gekennzeichnete Syndrome untersucht.

Werden mehr als zwei Fehler erkannt, ist die Korrekturfähigkeit der ersten Stufe erschöpft. An den Ausgängen 24 des rückgekoppelten Speichers 23 liegt ein Fehlermuster an, das einen weiteren Fehler kennzeichnet. Nach Abschluss der Korrektur- und Auslesephase wird über das OR-Gatter 26 und das OR-Gatter 38 ein Interpolationsaufruf vorgenommen.

Die zweite Stufe, die Fehlererkennungsstufe, besteht aus dem rückgekoppelten Speicher 32, dem OR-Gatter 38 und dem Ausgang 36. Die Daten, die aus dem Speicher 17 ausgelesen werden, werden gleichzeitig in den rückgekoppelten Speicher 32 eingelesen. Dort werden sie auf Teilbarkeit durch das Teilpolynom F überprüft. Kennzeichnet das Prüfergebnis ein Syndrom ungleich Null, wird nach Ablauf der Auslesephase ein Interpolationsaufruf über den Ausgang 36 vorgenommen, so dass der fehlerhafte Abtastwert in einer nachgeschalteten Interpolationsstufe in der Weise korrigiert werden kann, dass der fehlerhafte Wert durch den Mittelwert des zeitlich vorangehenden und nachfolgenden Abtastwertes ersetzt wird: In der zweiten Stufe ist es möglich, weitere drei Fehler zu erkennen und nach Ablauf der Auslesephase zu interpolieren.

Nachdem alle 63 Bit aus dem Speicher 17 ausgelesen sind, wird bei vorhandenem Syndrom ungleich Null in der ersten Stufe über die OR-Gatter 26 und 38 ein weiterer Interpolationsaufruf ermöglicht. Dieser Fall tritt teilweise bei mehr als fünf Fehlern auf, wenn das fehlerhafte Codewort keinem Korrekturbereich zugeordnet werden kann. In diesem Fall wird ebenfalls ein Interpolationsaufruf vorgenommen, so dass sich die mittlere Übertragungszeit ohne Knackstörung erhöht.

Das Teilpolynom E ergibt multiplikativ verknüpft mit dem Teilpolynom F das Generatorpolynom des BCH-Codes 63/44 für den Encoder.

Der rückgekoppelte Speicher 23 in der Fig. 1 benötigt 12 Flip-Flops, der Festwertspeicher 29 umfasst dabei $2^{12}$ Speicherplätze. Bei der Verwendung des Generatorpolynoms für die Decodervariante A erhöht sich die Anzahl der Flip-Flops auf 18. Der Festwertspeicher 29 benötigt $2^{18}$ Speicherstellen. Für die Decodervariante A ergeben sich 1954 zu kennzeichnende Syndrome.

Da bei der Fehlerkorrektur für die Decodervariante B nur 63 zu kennzeichnende Syndrome auftreten können, ergibt sich ein grosser Unterschied zu der Anzahl der in dem Festwertspeicher 29 verfügbaren Speicherplätze. Um den Hardwareaufwand für die Syndromerkennung zu minimieren, lässt sich der Festwertspeicher 29 durch ein mehrstufiges Schaltnetzwerk in Gate-Array-Technik ersetzen. Diskret aufgebaut werden für die Decodervariante B anstelle des Festwertspeichers 29 nur 63 NAND-Gatter benötigt, deren Eingänge entsprechende zu kennzeichnende Syndrome ungleich Null repräsentieren und die über ein OR-Gatter ein Korrektursignal liefern.

Das erfindungsgemässe System eignet sich nicht nur für die Satellitenübertragung, sondern ist auch für sämtliche andere Informationskanäle, in denen statistisch verteilte Einzelbitfehler (Gausssches Rauschen) auftreten, anwendbar.

## Patentansprüche

1. System zur Übertragung digitaler Informationssignale, insbesondere für digitale Tonübertragung über Satelliten, mit einem Coder auf der Sendeseite und einem Decoder auf der Empfangsseite, bei dem die zu übertragenden Informationssignale auf der Sendeseite mit einem Generatorpolynom verknüpft werden, in der Weise, dass den zu übertragenden Informationssignalen Prüfstellen zugeordnet werden, die aus einer arithmetischen Verknüpfung der Informationssignale mit dem Generatorpolynom erstellt werden, dadurch gekennzeichnet, dass ein primitiver BCH-Code mit der Blocklänge 63 bit und 18 Prüfstellen verwendet wird, dessen Generatorpolynom

$$x^{18} + x^{17} + x^{16} + x^{15} + x^9 + x^7 + x^6 + x^3 + x^2 + x + 1$$

mit dem weiteren Generatorpolynom $x + 1$ multiplikativ verknüpft wird, so dass ein Generatorpolynom für den Encoder

$$x^{19} + x^{15} + x^{10} + x^9 + x^8 + x^6 + x^4 + 1$$

mit einer Blocklänge von 63 bit und 19 Prüfstellen entsteht, so dass empfangsseitig durch Anwendung unterschiedlicher Dekoderstrategien die Korrektur von drei Fehlern und die Erkennung von vier Fehlern oder die Korrektur von zwei Fehlern und die Erkennung von fünf Fehlern oder die Korrektur von einem Fehler und die Erkennung von sechs Fehlern oder die Erkennung von sieben Fehlern durchgeführt wird, wobei die Fehlererkennung zum Aufruf einer Fehlerverdeckungsmassnahme genutzt wird.

2. System nach Anspruch 1, dadurch gekennzeichnet, dass die Informationssignale eine Folge von Datenwörtern aus einem Bündel zu übertragender Stereosignale zwei Stereokanäle oder vier Monosignale darstellen, wobei jeweils vier Datenworte der Informationssignale zusammengefasst werden.

3. System nach Anspruch 2, dadurch gekennzeichnet, dass jedes Datenwort eines Einzelkanals, das 14 Bit umfasst, in elf höherwertige Bit und drei niederwertige Bit aufgespalten wird und nur die vier aneinandergereihten elf höherwertigen Bit mit dem zyklischen Code verknüpft werden.

4. Schaltungsanordnung zur Realisierung des Systems nach Anspruch 1, dadurch gekennzeichnet, dass die empfangenen Informationssignale einer ersten Stufe des Decoders zugeführt werden, in der ein Teil der auftretenden Fehler der empfangenen Informationssignale erkannt und korrigiert wird und daran anschliessend einer zweiten Stufe zugeführt werden, in der ein weiterer Teil der Fehler erkannt wird.

5. Schaltung nach Anspruch 4, dadurch gekennzeichnet, dass sich an die zweite Stufe eine Interpolationsstufe anschliesst, in der ein fehlerhaft erkanntes aber nicht mehr korrigierbares Datenwort des ankommenden Informationssignals durch Verwendung von zeitlich benachbarten Codewörtern linear oder in höherer Ordnung interpoliert wird.

6. Schaltung nach Anspruch 4, dadurch gekennzeichnet, dass die erste Stufe des Decoders einen ersten Speicher (17) und einen zweiten, rückgekoppelten Speicher (23) aufweist, in die die ankommenden Informationssignale gleichzeitig eingelesen werden.

7. Schaltung nach Anspruch 4, dadurch gekennzeichnet, dass die Informationssignale beim Einlesen in den zweiten, rückgekoppelten Speicher (23) mit einem ersten Teilpolynom (E) arithmetisch verknüpft werden.

8. Schaltung nach Anspruch 7, dadurch gekennzeichnet, dass das erste Teilpolynom (E) ein Polynom

$$x^{12} + x^{10} + x^8 + x^5 + x^4 + x^3 + 1$$

ist.

9. Schaltung nach Anspruch 7, dadurch gekennzeichnet, dass nach Einlesen der Informationssignale in den ersten Speicher (17) und in den zweiten, rückgekoppelten Speicher (23) die Informationssignale in einem mit den Ausgängen (24) des zweiten rückgekoppelten Speichers (23) verbundenen Festwertspeicher (29) auf Syndrom gleich Null überprüft werden.

10. Schaltung nach Anspruch 9, dadurch gekennzeichnet, dass beim Auftreten eines Übertragungsfehlers mit einem Bitfehler eine Adresse des Festwertspeichers (29) aufgerufen wird, die am Ausgang (30) des Festwertspeichers (29) ein Korrektursignal setzt, und dass mit Hilfe des Korrektursignals ein Bitfehler und das dem Fehlermuster zugeordnete Syndrom korrigiert wird.

11. Schaltung nach Anspruch 10, dadurch gekennzeichnet, dass beim vorhandenen Korrektursignal am Ausgang (30) des Festwertspeichers (29) über ein Gatter (20) das fehlerhafte Bit des am Ausgang (18) des ersten Speichers (17) anstehende Informationssignal korrigiert wird.

12. Schaltung nach Anspruch 4, dadurch gekennzeichnet, dass die aus dem ersten Speicher (17) ausgelesenen Informationssignale an einem Ausgang (37) abgreifbar sind und gleichzeitig in einen dritten, rückgekoppelten Speicher (32) der zweiten Stufe eingelesen werden.

13. Schaltung nach Anspruch 12, dadurch gekennzeichnet, dass die Informationssignale beim Einlesen in den dritten rückgekoppelten Speicher mit einem zweiten Teilpolynom (F) arithmetisch verknüpft werden.

14. Schaltung nach Anspruch 13, dadurch gekennzeichnet, dass das zweite Teilpolynom (F) ein Polynom

$$x^7 + x^5 + x^3 + 1$$

ist.

15. Schaltung nach Anspruch 11, dadurch gekennzeichnet, dass beim Auftreten eines Syndroms ungleich Null an den Ausgängen (34) des dritten rückgekoppelten Speichers (32) über ein Gatter (38) ein Signal für einen Interpolationsaufruf (36) gesetzt wird.

16. Schaltung nach Anspruch 10, dadurch gekennzeichnet, dass beim Überschreiten der Korrekturkapazität der ersten Stufe und nach Ablauf der Korrektur- und Auslesephase über ein Gatter (26) und ein Gatter (38) ein Interpolationsaufruf vorgenommen wird.

17. Schaltungsanordnung nach Anspruch 1, dadurch gekennzeichnet, dass auf der Sendeseite ein Coder zur Codierung der digitalen Informationssignale verwendet wird.

18. Schaltung nach Anspruch 17, dadurch gekennzeichnet, dass ein Code mit einem Generatorpolynom folgenden Aufbaus verwendet wird

$$x^{19} + x^{15} + x^{10} + x^9 + x^8 + x^6 + x^4 + 1.$$

**Revendications**

1. Système pour la transmission de signaux numériques d'informations, en particulier pour la transmission numérique du son au moyen de satellites, avec un codeur du côté de l'émission et un décodeur du côté de la réception, dans lequel les signaux d'informations à transmettre sont combinés du côté de l'émission avec un polynôme générateur, de façon qu'aux signaux d'informations à transmettre soient affectés des points de contrôle qui sont établis à partir d'une combinaison arithmétique des signaux d'information avec le polynôme générateur, caractérisé en ce qu'on utilise un code BOSE-CHAUDHURI'HOCQUENGHEM (BCH) primitif ayant une longueur de 63 bits et 18 points de contrôle, dont le polynôme générateur est de la forme:

$$x^{18} + x^{17} + x^{16} + x^{15} + x^9 + x^7 + x^6 + x^3 + x^2 + x + 1$$

et est combiné par multiplication avec l'autre polynôme générateur $x + 1$, de façon qu'il en ressorte un polynôme générateur pour le codeur de la forme:

$$x^{19} + x^{15} + x^{10} + x^9 + x^8 + x^6 + x^4 + 1$$

avec une longeur de 63 bits et 19 points de contrôle, de sorte que, du côté réception, par l'emploi de diverses stratégies de décodage on réalise la correction de trois erreurs et la reconnaissance de quatre erreurs, ou la correction de deux erreurs et la reconnaissance de cinq erreurs, ou la correction d'une erreur et la reconnaissance de six erreurs, ou la reconnaissance de sept erreurs, la reconnaissance d'erreur étant utilisée pour l'appel d'une mesure masquant l'erreur.

2. Système selon la revendication 1, caractérisé en ce que les signaux d'informations représentent une succession de mots de données d'un faisceau de signaux stéréo pour transmettre deux canaux stéréo ou quatre signaux mono, les quatre mots de données des signaux d'informations étant chaque fois groupés.

3. Système selon la revendication 2, caractérisé en ce que chaque mot de données d'un canal individuel, qui englobe 14 bits est subdivisé en onze bits de poids fort et trois bits de poids faible, seuls quatre bits consécutifs des onze bits de poids fort étant combinés avec le code cyclique.

4. Circuit pour la réalisation du système selon la revendication 1, caractérisé en ce que les signaux d'informations reçus sont amenés à un premier étage du décodeur, dans lequel une partie des erreurs des signaux d'information reçus est reconnue et corrigée, et ensuite à un second étage, dans lequel une autre partie des erreurs est reconnue.

5. Circuit selon la recendication 4, caractérisé en ce que le second étage est suivi d'un étage d'interpolation, dans lequel un mot de données du signal d'informations incident, reconnu comme erroné mais non plus corrigible, est interpolé linéairement ou selon un ordre plus élevé par l'emploi de mots code se succédant dans le temps.

6. Circuit selon la revendication 4, caractérisé en ce que le premier étage du décodeur présente une première mémoire (17) et une deuxième mémoire (23) à rétrocouplage, dans lesquelles les signaux d'informations incidents sont simultanément mémorisés.

7. Circuit selon la revendication 4, caractérisé en ce que les signaux d'informations, lorsqu'ils sont mémorisés dans la deuxième mémoire (23) à rétrocouplage, sont combinés arithmétiquement avec un premier sous-polynôme (E).

8. Circuit selon la revendication 7, caractérisé en ce que le premier sous-polynôme (E) est un polynôme de la forme:

$$x^{12} + x^{10} + x^8 + x^5 + x^4 + x^3 + 1.$$

9. Circuit selon la revendication 7, caractérisé en ce que, après l'introduction des signaux d'informations dans la première mémoire (17) et dans la deuxième mémoire (23) à rétrocouplage les signaux d'informations sont testés dans une mémoire morte (29) reliée aux sorties (24) de la deuxième mémoire à rétrocouplage (23), selon un syndrome égal à zéro.

10. Circuit selon la revendication 9, caractérisé en ce que, en présence d'une erreur de transmission avec une erreur de bit, une adresse de la mémoire morte (29) est appelée, qui positionne à la sortie (30) de la mémoire morte (29) un signal de correction, et en ce qu'avec l'aide du signal de correction, on corrige une erreur de bit et le syndrome affecté au modèle d'erreur.

11. Circuit selon la revendication 10, caractérisé en ce que l'on corrige avec un signal de correction existant à la sortie (30) de la mémoire morte (29), par l'intermédiaire d'une porte (20), le bit défectueux du signal d'informations présent à la sortie (18) de la première mémoire (17).

12. Circuit selon la revendication 4, caractérisé en ce que les signaux d'informations extraits de la première mémoire (17) sont prélevés à une sortie (37) et sont simultanément emmagasinés dans une troisième mémoire (32) à rétrocouplage du second étage.

13. Circuit selon la revendication 12, caractérisé en ce que les signaux d'informations, lors de l'introduction dans la troisième mémoire à rétrocouplage, sont combinés arithmétiquement avec un second sous-polynôme (F).

14. Circuit selon la revendication 13, caractérisé en ce que le second sous-polynôme (F) est un polynôme de la forme:

$$x^7 + x^5 + x^3 + 1$$

15. Circuit selon la revendication 11, caractérisé en ce qu'à l'apparition d'un syndrome différent de zéro aux sorties (34) de la troisième mémoire à rétrocouplage (32), un signal est émis pour un appel d'interpolation (36), par l'intermédiaire d'une porte (38).

16. Circuit selon la revendication 10, caractérisé en ce que, après franchissement la capacité de correction du premier étage et après déroulement de la phase de correction et d'extraction on initie un appel à travers une porte (26) et une porte (38).

17. Système selon la revendication 1, caractérisé en ce que du côté de l'émission, on emploie un codeur pour le codage des signaux numériques d'informations.

18. Système selon la revendication 17, caractérisé en ce qu'on emploie un code avec un polynôme générateur de la forme suivante:

$$x^{19} + x^{15} + x^{10} + x^9 + x^8 + x^6 + x^4 + 1.$$

**Claims**

1. System for the transmission of digital information signals, especially for digital sound transmission by satellites, having an encoder at the sending side and a decoder at the receiving side, in which the information signals to be transmitted are combined with a generator polynomial at the sending side in such a way that check places are associated with the information signals to be transmitted which are established from an arithmetical combination of the information signal with the generator polynomial, characterized in that a primitive BCH − code is used having the block length of 63 bits an 18 check places, of which the generator polynomial

$$x^{18} + x^{17} + x^{16} + x^{15} + x^9 + x^7 + x^6 + x^3 + x^2 + x^1 + 1$$

is multiplicatively combined with the further generator polynomial x + 1, so that a generator polynomial for the encoder

$$x^{19} + x^{15} + x^{10} + x^9 + x^8 + x^6 + x^4 + 1$$

arises having a block length of 63 bits and 19 check places, so that at the receiving side as a result of the use of different decoding strategies there is carried out the correction of three errors and the recognition of four errors or the correction of two errors and the recognition of five errors or the correction of one error and the recognition of six errors or the recognition of seven errors, whereby the error recognition is used for the initiation of an error concealment measure.

2. System according to Claim 1, characterized in that the information signals exhibit a sequence of data words from a bundle of stereo signals to be transmitted on two stereo channels or of four mono signals, whereby four data words of the information signals are collected together.

3. System according to Claim 2, characterized in that each data word of a single channel, which comprises 14 bits, is separated into eleven higher value bits and three lower value bits and only the four eleven high value bits which are arranged against one another in a row are combined with the cyclic code.

4. Circuit arrangement for the realisation of the system according to Claim 1, characterized in that the incoming information signals are applied to a first stage of the decoder, in which a part of the errors occurring in the incoming information signals is recognised and corrected, and directly thereupon are applied to a second stage, in which a further part of the errors are recognised.

5. Circuit according to Claim 4, characterized in that there is connected to the second stage an interpolation stage in which a data word of the incoming information signal, recognised as being incorrect but no longer capable of correction, is interpolated linearly or to a higher order by utilising codewords adjacent in time.

6. Circuit according to Claim 4, characterized in that the first stage of the decoder comprises a first store (17) and a second, back coupled store (23) in which the incoming information signals are written simultaneously.

7. Circuit according to Claim 4, characterized in that the information signals on being written in the second, back coupled store (23) are combined arithmetically with a first part polynomial (E).

8. Circuit according to Claim 7, characterized in that the first part-polynomial (E) is a polynomial

$$x^{12} + x^{10} + x^8 + x^5 + x^4 + x^3 + 1.$$

9. Circuit according to Claim 7, characterized in that after writing the information signals in the first store (17) and in the second, back coupled store (23) the information signals are tested as regards the syndrome equal to zero in a fixed value store (29) coupled to the outputs (24) of the second, back coupled store (23).

10. Circuit according to Claim 9, characterized in that upon the occurrence of a transmission error associated with a bit error, an address of the fixed value store (29) is called upon which sets up at the output (30) of the fixed value store (29) a correction signal and that with the aid of the correction signal a bit error and the syndrome associated with the error pattern are corrected.

11. Circuit according to Claim 10, characterized in that on the occurrence of the derived correction signal at the output (30) of the fixed value store (29), the incorrect bit of the information signal at the output (18) of the first store (17) is corrected by way of the gate (20).

12. Circuit according to Claim 4, characterized in that the information signals read from the first store (17) can be extracted at an output (37) and are written simultaneously in a third, back coupled store (32) of the second stage.

13. Circuit according to Claim 12, characterized in that the information signals, upon being written in the third, back coupled store, are combined arithmetically with a second part-polynomial (F).

14. Circuit according to Claim 13, charaterized in that the second part-polynomial is a polynomial

$$x^7 + x^5 + x^3 + 1$$

15. Circuit according to Claim 11, characterized in that upon the occurrence of a syndrome not equal to zero at the outputs (34) of the third, back coupled store (32) a signal for an initiation of interpolation is established by way of a gate (38).

16. Circuit according to Claim 10, characterized in that upon the overstepping of the capacity of the first stage for correction and after the expiry of the correction and reading phase, an interpolation initiation is put in hand by way of a gate (26) and a gate (38).

17. Circuit according to Claim 17, characterized in that a coder for the encoding of the digital information signals is employed at the sending side.

18. Circuit according to Claim 17, characterized in that a code is used having a generator polynomial of the following form

$$x^{19} + x^{15} + x^{10} + x^9 + x^8 + x^6 + x^4 + 1.$$

Fig.1

1/2

| Decodervariante | A | B | C | D |
|---|---|---|---|---|
| Korrigierbare Fehler pro Block (63 bit) | 3 | 2 | 1 | 0 |
| Erkennbare Fehler pro Block (63 bit) | 4 | 5 | 6 | 7 |
| Teilpolynom (E) für Fehlerkorrektur (1.Stufe) | $x^{18}+x^{17}+x^{16}+x^{15}+x^{9}$ $+x^{7}+x^{6}+x^{3}+x^{2}+x+1$ | $x^{12}+x^{10}+x^{8}+x^{5}$ $+x^{4}+x^{3}+1$ | $x^{6}+x+1$ | — |
| Teilpolynom (F) für Fehlererkennung (2.Stufe) | $x+1$ | $x^{7}+x^{5}+x^{3}+1$ | $x^{13}+x^{9}+x^{8}+x^{7}$ $x^{3}+x^{2}+x+1$ | $x^{19}+x^{15}+x^{10}+x^{9}+x^{8}$ $+x^{6}+x^{4}+1$ |
| Sendepolynom | $x^{19}+x^{15}+x^{10}+x^{9}+x^{8}+x^{6}+x^{4}+1$ | | | |

Fig. 2

0 073 979